# EUROPEAN PATENT APPLICATION

(11) **EP 2 466 367 A2**
(43) Date of publication of application: **20.06.2012**
(21) Application number: 11194029.2
(22) Date of filing: 16.12.2011
(51) Int. Cl.: G02F 1/13357, H01L 33/50, F21K 99/00

(54) **Light emitting module and backlight unit using the same**

(30) Priority: 16.12.2010 KR 20100128994
(71) Applicant: Samsung LED Co., Ltd., Yongin-City, Gyeonggi-Do (KR)
(72) Inventor: Jang, Kyu Ho, Gyeonggi-do (KR)
(74) Representative: Grünecker, Kinkeldey, Stockmair & Schwanhäusser

(57) **Abstract**

There is provided a light emitting module including: a circuit board; at least one light source part disposed on the circuit board; a wavelength conversion part coupled with the circuit board, the wavelength conversion part covering a light emitting surface of the light source part and converting a wavelength of light; and a coupling part coupling the wavelength conversion part to the circuit board.

## Description

### CROSS-REFERENCE TO RELATED APPLICATIONS

This application claims the priority of Korean Patent Application No. 10-2010-0128994 filed on December 16, 2010, in the Korean Intellectual Property Office, the disclosure of which is incorporated herein by reference.

### BACKGROUND OF THE INVENTION

### Field of the Invention

The present invention relates to a light emitting module and a backlight unit using the same.

### Description of the Related Art

A light emitting diode (LED) is a semiconductor device that can emit light of various colors due to electron-hole recombination occurring at a p-n junction when a current is supplied thereto.

LEDs are greatly advantageous over filament-based light emitting devices since LEDs have a long lifespan, low power usage, superior initial-operation characteristics, and high vibration resistance. These factors have continually boosted the demand for LEDs.

Particularly, group III nitride semiconductors that can emit light in the blue/short wavelength region have recently drawn much attention.

Meanwhile, in the case of a light emitting module used as a light source of a liquid crystal display (LCD) backlight unit, a cold cathode fluorescent lamp (CCFL) has conventionally been used. The CCFL employs mercury gas, which may trigger environmental pollution. Besides, the CCFL is slow in response rate, low in color reproducibility and inappropriate for a smaller-sized and lighter-weight LCD panel.

In contrast, an LED is environmentally-friendly, high in response rate with several nano seconds, thus effective for a video signal stream and capable of being impulsively driven.

Moreover, the LED can reproduce color by 100% and alter brightness and color temperature by adjusting the amount of light emitted by red, green and blue LEDs. Also, the LED may be advantageously used in smaller-sized and lighter-weight LCD panels. Therefore, of late, the LED has been actively employed in a light emitting module for a backlight unit.

### SUMMARY OF THE INVENTION

An aspect of the present invention provides a light emitting module having superior color reproducibility and light emitting efficiency while having improved reliability by creating a stable coupling, and a backlight unit using the same.

An aspect of the present invention also provides a light emitting module improved in operational efficiency in terms of simplification in the manufacturing and assembly processes thereof and allowing for a reduction in costs by standardizing a wavelength conversion part as compared with a conventional method of applying phosphors to a light emitting device, and a backlight unit using the same.

An aspect of the present invention also provides a light emitting module avoiding changes in the light emission characteristics of a light emitting device package by preventing the deterioration of a wavelength conversion part that may be caused by heat generated from a light emitting device since it is not necessary to coat an adhesive in order to apply phosphors to an upper surface of a light emitting diode package, and a backlight unit using the same.

According to an aspect of the present invention, there is provided a light emitting module including: a circuit board; at least one light source part disposed on the circuit board; a wavelength conversion part coupled with the circuit board, the wavelength conversion part covering a light emitting surface of the light source part and converting a wavelength of light; and a coupling part coupling the wavelength conversion part to the circuit board.

The wavelength conversion part may include at least one of a nanophosphor and a quantum dot.

The coupling part may include at least one opening portion and at least one protruding portion respectively provided on the circuit board and the wavelength conversion part such that the opening portion corresponds to the protruding portion.

The protruding portion may include a pair of coupling portions divided by a space in a vertical direction and projecting portions at ends of the coupling portions such that the projecting portions are caught by the opening portion.

The circuit board may have a bar shape.

The wavelength conversion part may have a bar shape and include extended portions at both ends thereof, the extended portions having the coupling part.

The coupling part may include at least one opening portion formed in an upper surface of the circuit board; and at least one protruding portion protruding downwardly from the wavelength conversion part and corresponding to the opening portion of the circuit board.

The coupling part may include at least one opening portion formed in the wavelength conversion part; and at least one protruding portion protruding from an upper surface of the circuit board and corresponding to the opening portion of the wavelength conversion part.

The wavelength conversion part may have vertical wall portions at both sides thereof, and the coupling part may include linear protrusions formed inwardly of the vertical wall portions of the wavelength conversion part and groove portions formed at both sides of the circuit board and corresponding to the linear protrusions of the wavelength conversion part.

The wavelength conversion part may have vertical wall portions at both sides thereof, and the coupling part may include linear protrusions formed outwardly at both sides of the circuit board and groove portions formed at inner surfaces of the vertical wall portions of the wavelength conversion part and corresponding to the linear protrusions of the circuit board.

According to another aspect of the present invention, there is provided a backlight unit including: a light emitting module; and a light guide plate disposed on a path of light emitted from the light emitting module, wherein the light emitting module includes at least one light source part disposed on a circuit board, and a wavelength conversion part coupled with the circuit board by a coupling part, the wavelength conversion part covering a light emitting surface of the light source part and converting a wavelength of the light.

The light source part may include a package body having a mounting area; and a light emitting device disposed in the mounting area.

The light emitting device may be a blue light emitting diode (LED) chip.

The circuit board may have a bar shape, and a plurality of light source parts may be arrayed in a lengthwise direction of the circuit board.

The backlight unit may further include a chassis having the light emitting module and the light guide plate therein.

The circuit board may be installed in a vertical manner to cause a circuit pattern thereof to be directed laterally, and the light source part may be disposed on the circuit board to emit light in a direction in which the circuit pattern is formed.

The circuit board may be installed in a horizontal manner to cause a circuit pattern thereof to be directed upwardly, and the light source part may be disposed on the circuit board to emit light in a horizontal direction of the circuit board. The wavelength conversion part may have a vertical wall portion on at least one side thereof so as to cover the light emitting surface of the light source part.

### BRIEF DESCRIPTION OF THE DRAWINGS

The above and other aspects, features and other advantages of the present invention will be more clearly understood from the following detailed description taken in conjunction with the accompanying drawings, in which:
FIG. 1 is a perspective view illustrating a light source part of a light emitting module according to an exemplary embodiment of the present invention;
FIG. 2 is an elevation view of FIG. 1;
FIG. 3 is a perspective view illustrating a light emitting module according to an exemplary embodiment of the present invention;
FIG. 4 is an exploded perspective view illustrating a light emitting module according to an exemplary embodiment of the present invention;
FIG. 5 illustrates an enlarged portion of FIG. 4;
FIG. 6 illustrates an enlarged portion of FIG. 4 viewed from below;
FIG. 7 is an exploded perspective view illustrating a light emitting module according to another exemplary embodiment of the present invention;
FIG. 8 is an exploded perspective view illustrating a light emitting module according to another exemplary embodiment of the present invention;
FIG. 9 is an assembled perspective view of FIG. 8;
FIG. 10 is a view illustrating an end of the light emitting module of FIG. 9;
FIG. 11 is an exploded perspective view illustrating a light emitting module according to another exemplary embodiment of the present invention;
FIG. 12 is an assembled perspective view of FIG. 11;
FIG. 13 is a view illustrating an end of the light emitting module of FIG. 12;
FIG. 14 is a perspective view illustrating a backlight unit except for a light guide plate according to an exemplary embodiment of the present invention; and
FIG. 15 is a perspective view illustrating the backlight unit of FIG. 14 coupled with a light guide plate.
FIG. 16 is a graph of color reproducibility.

### DETAILED DESCRIPTION OF THE PREFERRED EMBODIMENT

Exemplary embodiments of the present invention will now be described in detail with reference to the accompanying drawings.

The invention may, however, be embodied in many different forms and should not be construed as being limited to the embodiments set forth herein. Rather, these embodiments are provided so that this disclosure will be thorough and complete, and will fully convey the scope of the invention to those skilled in the art.

In the drawings, the shapes and dimensions may be exaggerated for clarity, and the same reference numerals will be used throughout to designate the same or like components.

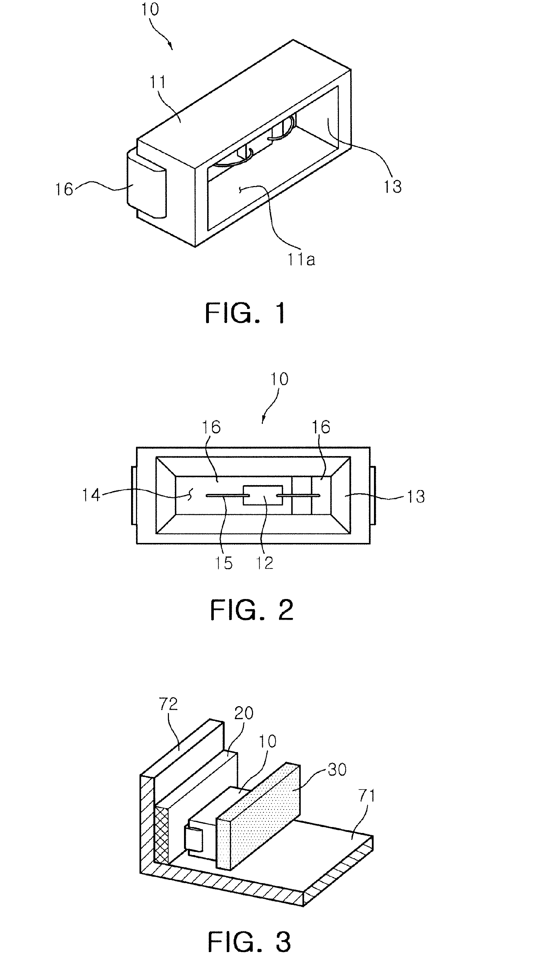

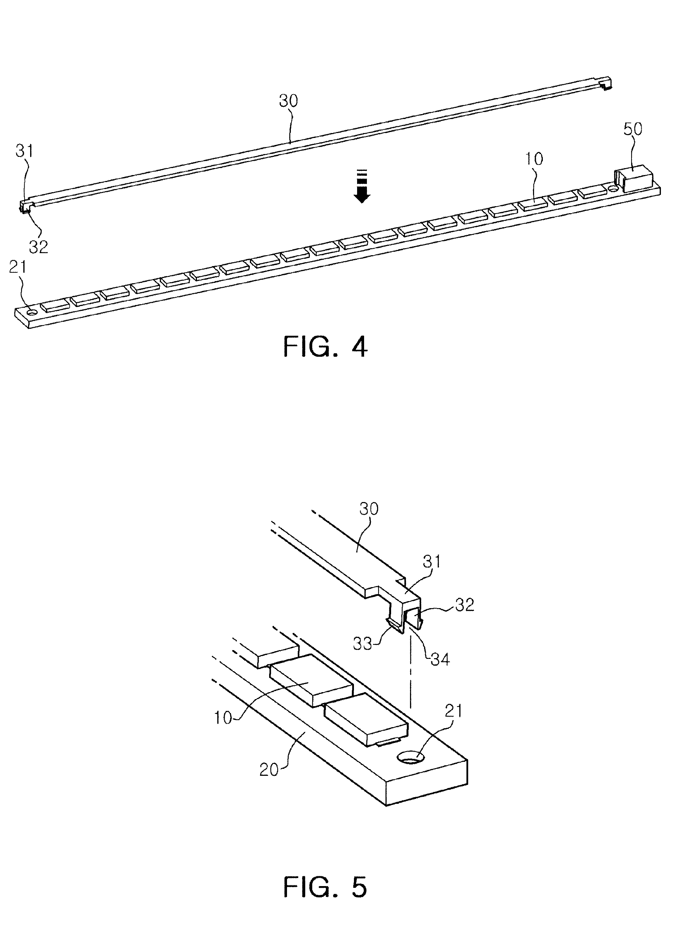

Referring to FIGS. 1 through 6, a light emitting module according to an exemplary embodiment of the invention includes a circuit board 20, at least one light source part 10 disposed on the circuit board 20, and a wavelength conversion part 30 disposed to cover a light emitting surface of the light source part 10 and allow a wavelength of light to be converted.

As shown in FIGS. 1 and 2, the light source part 10 may include a package body 11 having a mounting area 11a therein and a light emitting device 12 disposed within the mounting area 11a of the package body 11.

The light emitting device 12 may employ a photoelectric device emitting light when an electrical signal is applied thereto. A light emitting diode (LED) chip may be a representative light emitting device. For example, a GaN-based LED chip emitting blue light may be used therefor, and at least part of the blue light may be converted into light of a different color, preferably white light, by the wavelength conversion part 30.

A reflective part 13 may be provided on an inner wall of the package body 11 to be inclined at a predetermined angle. The mounting area 11a may narrow in a direction toward a surface on which the light emitting device 12 is mounted due to the inclination of the reflective part 13, a width of the interior of the package body 11 may become narrow.

The reflective part 13 may reflect light emitted from the light emitting device 12 to thereby improve external light extraction efficiency. To enable this, the reflective part 13 may be formed by plating a highly reflective metal, e.g., at least one of Ag, Ni, Al, Rh, Pd, Ir, Ru, Mg, Zn, Pt, Au and a mixture thereof or by attaching a separate reflective sheet formed of such a highly reflective metal to the interior of the package body 11.

The light emitting device 12 may be disposed on a pair of lead frames 16 in the interior of the package body 11.

The pair of lead frames 16 may be electrically connected to the light emitting device 12 through a pair of conductive wires 15. One of the lead frames 16 may be provided as a mounting area of the light emitting device 12.

The lead frames 16 may be formed of a metal having superior electrical and thermal conductivity, e.g., Au, Ag, Cu or the like, such that they can be used as electrode terminals for applying external electrical signals to the circuit board in a manner in which part of the lead frames are exposed to the outside of the package body 11 when a light emitting device package is mounted on the circuit board.

In the present embodiment, a pair of electrodes connected to the light emitting device 12 are disposed on the top of the lead frames 16 and the light emitting device 12 is connected to the lead frames 16 through the pair of conductive wires 15; however, the invention is not limited thereto. A connection method may be varied according to exemplary embodiments of the invention.

For example, the light emitting device 12 may be directly electrically connected to one of the lead frames 16 provided as the mounting area thereof without using the wire 15, while being connected to the other lead frame 16 by the wire 15.

As another example, the light emitting device 12 may be disposed in the mounting area 11a of the package body 11 in a flip-chip bonding manner without a conductive wire.

Meanwhile, in the present embodiment, a single light emitting device 12 is disposed in the package body 11; however, the invention is not limited thereto. Two or more light emitting devices 12 may be disposed therein.

Furthermore, a conductive wire is used as an example of a wiring structure; however, it may be replaced with various types of wiring structure, e.g., a metal line, so long as electrical signals may be transferred therethrough.

The package body 11 may include the mounting area 11a allowing the light emitting device 12 to be exposed, and may serve to fix at least one pair of lead frames 16 on which the light emitting device 12 is mounted.

The package body 11 may be formed of a material having electrical insulation while being superior in thermal emission and light reflectivity properties; however, the material of the package body 11 is not particularly limited thereto. In light of this, the package body 11 may be formed of a transparent resin and have a structure in which light reflective particles, e.g., TiO₂, are dispersed in a transparent resin.

An encapsulation part 14 may be formed in the mounting area 11a of the package body 11 in a manner in which the encapsulation part 14 may cover the light emitting device 12 in a path of light emitted from the light emitting device 12.

The encapsulation part 14 may be formed of a silicone-or epoxy-based transparent resin. The encapsulation part 14 may protect the light emitting device 12 and the conductive wire 15 and allow for a refraction index matching of the light emitting device 12 with the outside of the package body 11, thereby improving external light extraction efficiency.

In addition, the encapsulation part 14 is formed to cover the light emitting device 12 within the mounting area 11a of the package body 11 and the wavelength conversion part 30 including a quantum dot is spaced apart from the light emitting device 20 as will be described below, and thus the deterioration of the wavelength conversion part 30 caused by heat generated from the light emitting device 12 may be prevented to thereby avoid changes in the luminance, sensitivity and refraction of light.

With reference to FIGS. 3 through 6, the circuit board 20 and the wavelength conversion part 30 may have a bar shape and the plurality of light source parts 10 may be arrayed on the bar-shaped circuit board 20 in a lengthwise direction thereof, and thus the manufacturing and assembly processes of a backlight unit (BLU) may be simplified.

The circuit board 20 may have opening portions 21 at both ends thereof and the wavelength conversion part 30 may have protruding portions at both ends thereof, the protruding portions protruding downwardly to correspond to the opening portions 21, such that the protruding portions of the wavelength conversion part 30 may be press-fit into the opening portions 21 of the circuit board 20.

Here, extended portions 31 may be formed at both ends of the wavelength conversion part 30 and the protruding portions may protrude from the extended portions 31. Each of the protruding portions may have a pair of coupling portions 32 divided by a space 34 having a predetermined depth in a vertical direction and projecting portions 33 formed at lower ends of the coupling portions 32. The projecting portion 33 may have a tapered shape in which an upper portion thereof is wide and a lower portion thereof is narrow.

The opening portion 21 of the circuit board 20 may be formed as a so-called counter board hole having a ridge 21a in an inner portion thereof such that the projecting portions 33 may be caught by the ridge 21a so as not to be separated therefrom.

Therefore, the coupling portions 32 of the protruding portion inserted into the opening portion 21 are slid along the opening portion 21 in a state of being pressed by the space 34. After passing the ridge 21a of the opening portion 21, the coupling portions 32 return backward due to elastic force and the projecting portions 33 are caught and supported by the ridge 21a of the opening portion 21 such that the protruding portion is coupled to the opening portion 21. That is, the coupling of the wavelength conversion part 30 and the circuit board 20 is maintained.

The circuit board 20 may be a printed circuit board (PCB) . The circuit board 20 may be formed of an organic resin material containing epoxy resin, triazine resin, silicone resin, polyimide resin, or the like, other organic resin materials, a ceramic material such as AlN, Al₂O₃ or the like, or metals and metallic compounds. Specifically, the circuit board 20 may be a metal core printed circuit board (MCPCB), one type of a metal PCB.

The circuit board 20 is not particularly limited so long as it has a wiring structure for driving the light source parts 10 in which the wiring structure is formed on a surface on which the light source parts 10 are mounted and a surface opposed thereto.

Specifically, a circuit pattern and a wiring pattern may be formed on one surface and the other surface of the circuit board 20 in order to make electrical connections with the individual light source parts 10. A wiring pattern formed on one surface of the circuit board 20 on which the light source parts 10 are mounted may be connected to a wiring pattern formed on the other surface opposed to one surface of the circuit board 20 by through-holes or bumps (not shown).

The wiring structure may be provided on the surface of the circuit board 20 in order to supply power to the light emitting module, and a separate power supply part 50 may be electrically connected to the circuit board 20 in order to supply power to the light emitting module.

In addition, a heat sink (not shown) may be provided for heat emission on the other surface of the circuit board 20 opposed to one surface thereof on which the light emitting module is mounted.

The heat sink may be formed of a material having superior thermal conductivity such as copper, aluminum, stainless steel or the like such that it may serve to absorb heat generated from the circuit board 20 and emit the heat to the outside. Heat dissipation may be increased by maximizing a surface area of the heat sink.

Furthermore, the circuit board 20 and the heat sink may be coupled by interposing a thermal interface material (not shown), such as a heat dissipation pad, a phase change material, a heat dissipation tape or the like, therebetween in order to minimize thermal resistance.

The wavelength conversion part 30 covers the light emitting surface of the light source part 10 and converts the wavelength of light emitted from the light emitting surface. The wavelength conversion part 30 may include a quantum dot (not shown).

The quantum dot may be a semiconductor nanocrystal having a diameter of approximately 1 nm to 10 nm and represent a quantum confinement effect. The quantum dot converts the wavelength of light emitted from the light emitting device 12 to thereby generate wavelength-converted light, i.e., fluorescent light.

For example, the quantum dot may be a nanocrystal such as an Si-based nanocrystal, a group II-VI compound semiconductor nanocrystal, a group III-V compound semiconductor nanocrystal, a group IV-VI compound semiconductor nanocrystal or the like. The preceding examples of the quantum dot may be used individually or combined in the present embodiment.

More specifically, the group II-VI compound semiconductor nanocrystal may be selected from the group consisting of CdS, CdSe, CdTe, ZnS, ZnSe, ZnTe, HgS, HgSe, HgTe, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HggZnTe, CdZnSeS, CdZnSeTe, CdZnSTe, CdHgSeS, CdHgSeTe, CdHgSTe, HgZnSeS, HgZnSeTe and HgZnSTe.

The group III-V compound semiconductor nanocrystal may be selected from the group consisting of GaN, GaP, GaAs, AlN, AlP, AlAs, InN, InP, InAs, GaNP, GaNAs, GaPAs, AlNP, AlNAs, AlPAs, InNP, InNAs, InPAs, GaAlNP, GaAlNAs, GaAlPAs, GaInNP, GaInNAs, GaInPAs, InAlNP, InAlNAs, and InAlPAs.

The group IV-VI compound semiconductor nanocrystal may be SbTe.

The quantum dot may be dispersed in a dispersion medium such as an organic solvent or a polymer resin by a coordinate bond. The dispersion medium may employ a transparent medium having no influence on the wavelength conversion function of the quantum dot while allowing for no degeneration change in quality and no reflection and absorption of light.

For example, the organic solvent may include at least one of toluene, chloroform and ethanol, and the polymer resin may include at least one of epoxy resin, silicone resin, polysthylene resin and acrylate resin.

Meanwhile, light emission in the quantum dot may be implemented by the transfer of excited electrons from a conduction band to a valence band. Even in the case of a quantum dot of the same material, the quantum dot may emit light having different wavelengths according to a particle size thereof.

As the size of the quantum dot is reduced, the quantum dot may emit short-wavelength light. Light having a desired wavelength band may be obtained by adjusting the size of the quantum dot. Here, the size of the quantum dot may be adjusted by appropriately changing the growth conditions of nanocrystals.

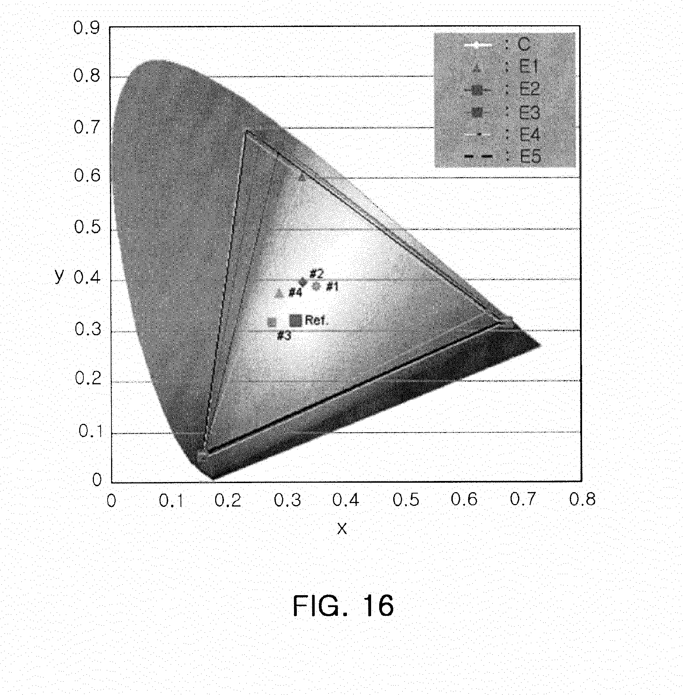

As described above, when the wavelength conversion part includes the quantum dot, the color reproducibility of the light source part 10 may be increased by at least 15% or more as shown in FIG. 16. The particle size and concentration of the quantum dot may be adjusted to thereby facilitate the control of color coordinates. In FIG. 16, a comparative example does not include a quantum dot. The C in FIG. 16 is comparative example, and the E1, E2, E3, E4 and E5 in FIG. 16 are inventive examples.

Meanwhile, in a case in which a material constituting the quantum dot reacts with a metal, the metal may be discolored, thereby failing to serve as a reflective layer directing the light emitted from the light emitting device 12 upwardly.

Therefore, in the present embodiment, the wavelength conversion part 30 is disposed so as not to contact the encapsulation part 14, encapsulating the light emitting device 12 in the package body 11, with a predetermined gap therebetween.

The wavelength conversion part 30 may further include a ceramic phosphor (not shown) or a nanophosphor for light wavelength conversion in addition to the quantum dot.

For example, a quantum dot and a phosphor, converting light emitted from the light emitting device 12 to have green and red wavelengths, respectively, are included in the wavelength conversion part 30 so that light having a plurality of wavelengths may be emitted.

The phosphor may include at least one of a YAG-based phosphor, a TAG-based phosphor, a silicate-based phosphor, a sulfide-based phosphor and a nitride-based phosphor.

In general, a phosphor included in the wavelength conversion part 30 is directly applied to an upper surface of the encapsulation part 14 encapsulating the mounting area 11a of the package body 11, and the applied phosphor is discolored due to heat generated from the light emitting device 12. As time goes by, the wavelength of light emitted therefrom and color distribution may change and color stains may occur.

However, in the present embodiment, an adhesive phosphor is not directly applied to the encapsulation part 14 and the wavelength conversion part 30 is spaced apart from the light source part 10, and thus there is provided a light emitting module avoiding discoloration caused by the deterioration of a conventional adhesive phosphor.

The coupling structure of the circuit board and the wavelength conversion part as described above is not particularly limited, and may be modified in various manners.

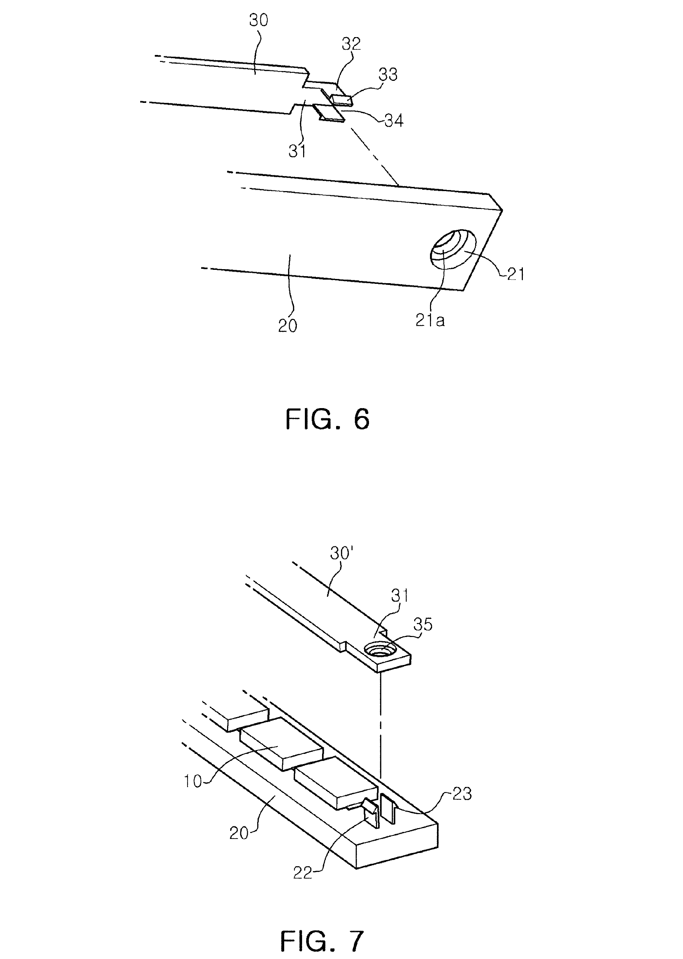

For example, referring to FIG. 7, protruding portions may protrude upwardly from both ends of an upper surface of a circuit board 20' and opening portions 35 may be formed in extended portions 31 extended from both ends of a wavelength conversion part 30' such that the protruding portions of the circuit board 20' may be press-fit into the opening portions 35.

Here, each of the protruding portions of the circuit board 20' may have a pair of coupling portions 22 divided by a space therebetween and projecting portions 23 formed at upper ends of the coupling portions 22. The projecting portion 23 may have a tapered shape in which a lower portion thereof is wide and an upper portion thereof is narrow.

The opening portion 35 of the wavelength conversion part 30' may be formed as a so-called counter board hole having a ridge in an inner portion thereof such that the projecting portions 23 may be caught by the ridge so as not to be separated therefrom.

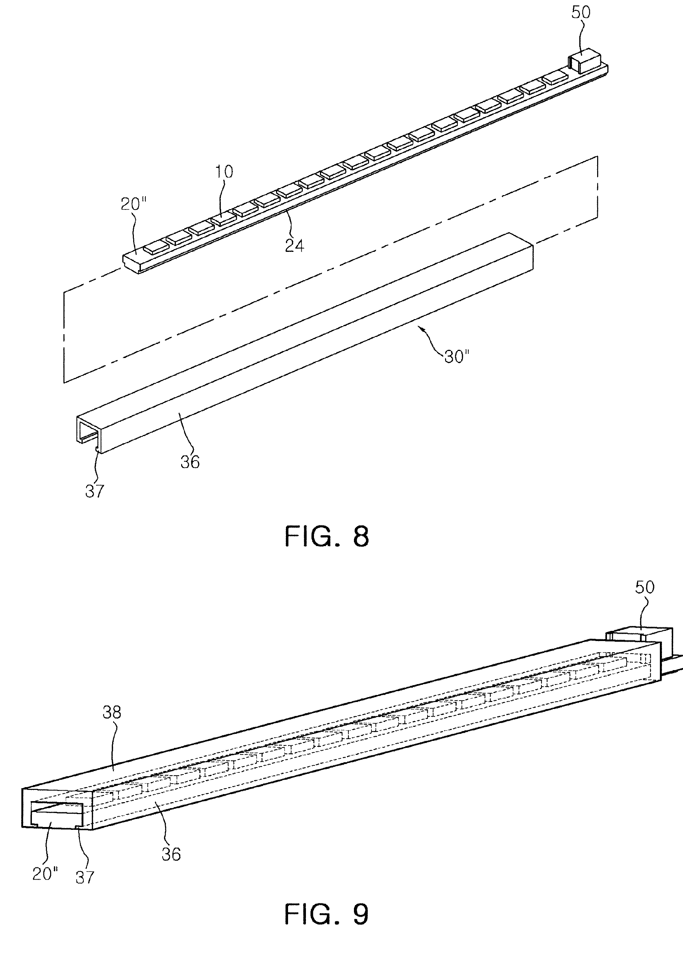

In another exemplary embodiment, with reference to FIGS. 8 through 10, a circuit board 20" and a wavelength conversion part 30" may be coupled in a sliding manner.

The wavelength conversion part 30" may have a horizontal portion 38 and vertical wall portions 36 extending from both sides of the horizontal portion 38. Linear protrusions 37 may be formed inwardly at lower ends of the individual vertical wall portions 36 and groove portions 24 may be formed at both sides of a lower surface of the circuit board 20'' in a lengthwise direction, such that the linear protrusions 37 of the wavelength conversion part 30" may be inserted into the groove portions 24.

Here, the power supply part 50 may have a height higher than that of the wavelength conversion part 30" such that it may serve as a stopper stopping the sliding of the wavelength conversion part 30'' when the circuit board 20'' is coupled with the wavelength conversion part 30'' in a sliding manner.

Meanwhile, the linear protrusion 37 may be formed at the center of the vertical wall portion 36 rather than the lower end thereof, and the groove portion 24 of the circuit board 20'' may be positioned correspondingly.

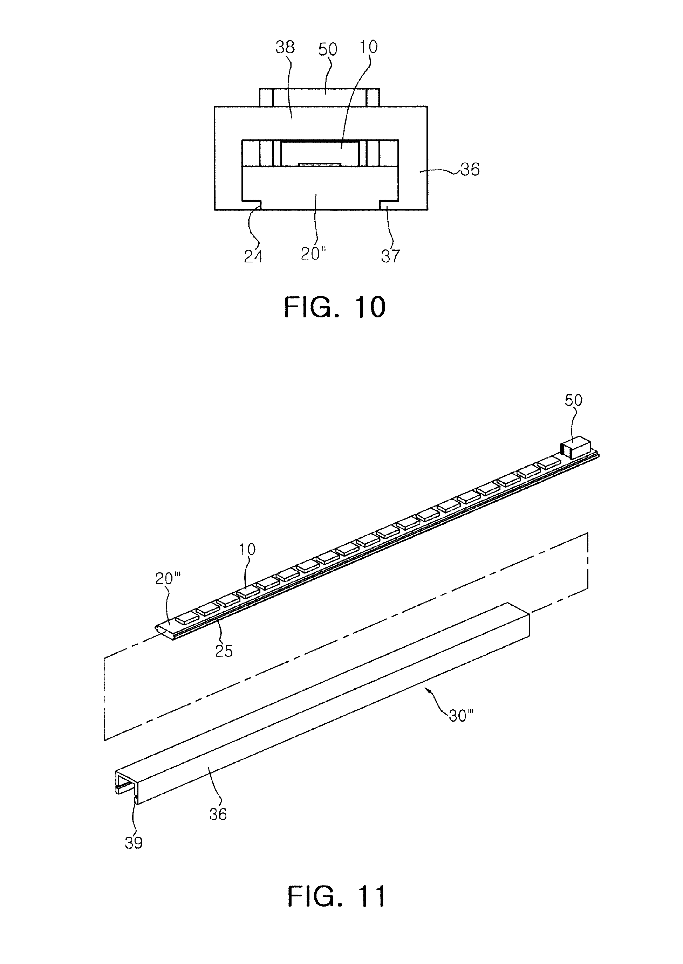

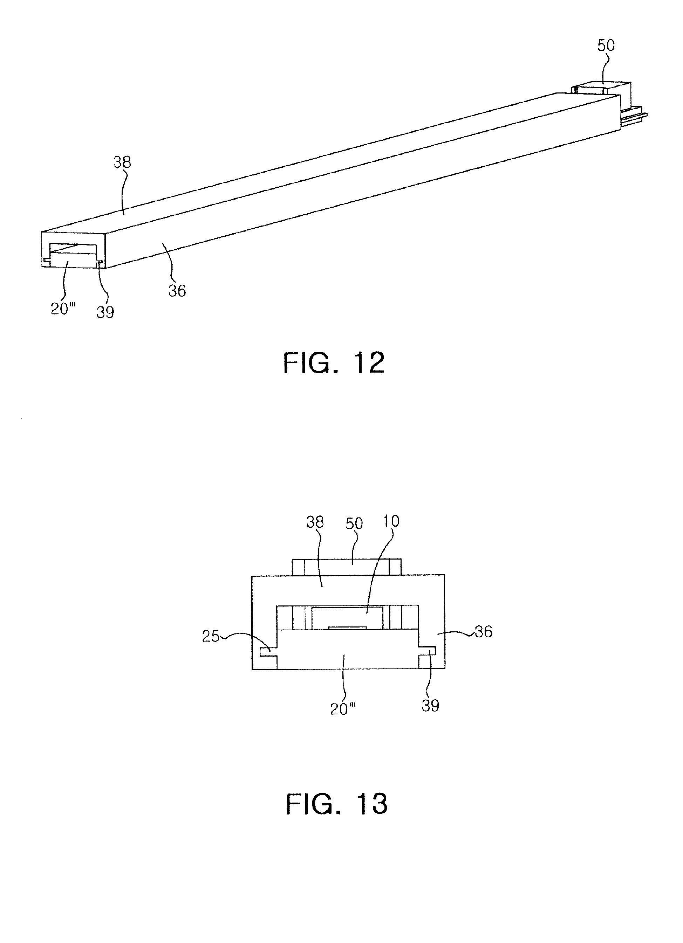

In another exemplary embodiment, with reference to FIGS. 11 through 13, a wavelength conversion part 30''' may have the horizontal portion 38 and the vertical wall portions 36 extending from both sides of the horizontal portion 38. Groove portions 39 may be formed inwardly of the individual vertical wall portions 36 in a lengthwise direction. Linear protrusions 25 may be formed at both sides of a circuit board 20''' in a lengthwise direction such that they may be inserted into the groove portions 39 of the wavelength conversion part 30'''.

As described in the previous embodiment, the power supply part 50 may serve as a stopper stopping the sliding of the wavelength conversion part 30''' when the circuit board 20''' is coupled with the wavelength conversion part 30''' in a sliding manner. Further, the positions of the linear protrusions 25 and the groove portions 39 may be properly modified.

The light emitting module according to the exemplary embodiments of the invention may be variously applicable to a backlight unit for a television, a lighting apparatus, a light source for a motor vehicle, a backlight unit for a cellular phone or the like.

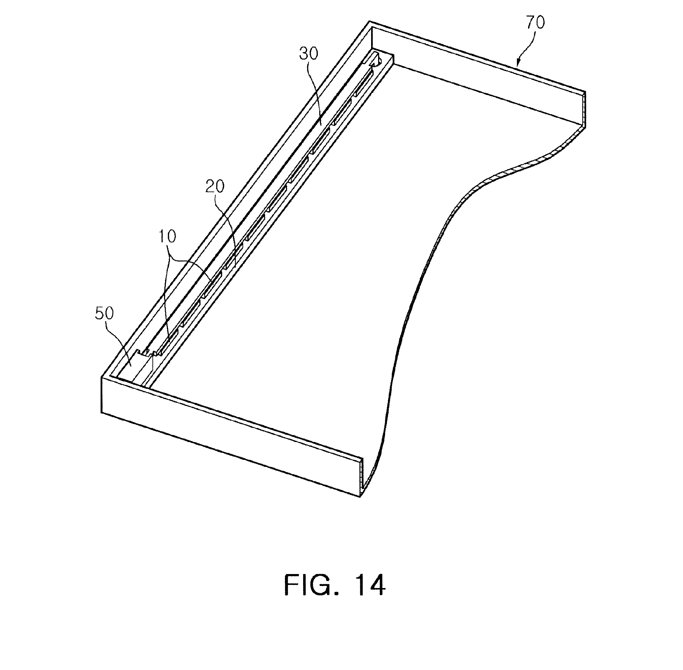

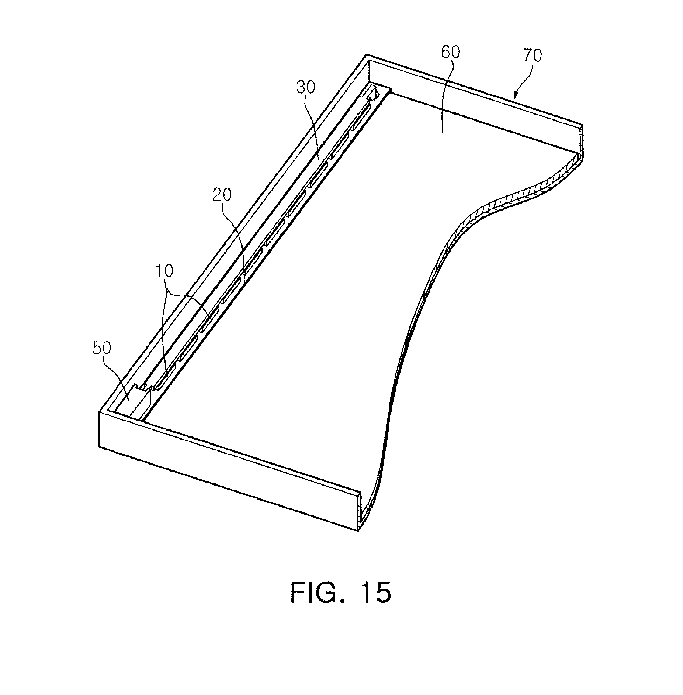

With reference to FIGS. 14 and 15, a backlight unit using a light emitting module according to an exemplary embodiment of the invention includes the above-described light emitting module and at least one light guide plate 60 disposed on a path of light emitted from the light emitting module.

The light guide plate 60 may be formed of a transparent resin such as PMMA in order to smoothly draw light incident to a light incident surface. The light guide plate 60 may have a specific pattern (not shown) such as unevenness or the like on a lower surface thereof such that it may allow light directed downward of the light guide plate 60 to be reflected upwardly.

Also, a reflective layer (not shown) may be further provided on side surfaces of the light guide plate 60 to allow light emitted laterally to be reflected inwardly.

In order to increase the overall brightness of the backlight unit by reducing the loss of light, a brightness enhancement film (BEF) or a dual brightness enhancement film (DBEF) may be further provided therein.

Meanwhile, in the above-described embodiments, the circuit board 20 is installed in a vertical manner to cause the circuit pattern thereof to be directed laterally, and the light source parts 10 are disposed on the circuit board 20 to emit light in a direction in which the circuit pattern is formed. The lead frames 16 are exposed to the bottom surface of the package body 11, i.e., the surface opposed to the mounting surface of the light emitting device.

However, the invention is not limited thereto. The installation and position of the circuit board and the light source part may be modified in various manners. For example, the circuit board 20 may be installed in a horizontal manner to cause the circuit pattern thereof to be directed upwardly, and the light source parts 10 may be disposed to emit light in a direction in which the circuit pattern is formed, i.e., in a horizontal direction of the circuit board. In this case, the lead frames 16 may be disposed on the side surface of the package body 11 rather than the bottom surface thereof.

In the case of mounting the wavelength conversion part 30 having a groove/protrusion structure, the wavelength conversion part 30 may have the vertical wall portion formed at one side of the horizontal portion so as to cover the light emitting surface of the light source part 10.

In addition, a chassis 70 having the light emitting module and the light guide plate 60 therein may be further included.

The chassis 70 may have a structure of an open top box in which a flat bottom surface 71 has the light guide plate 60 mounted thereon and side walls 72 extend upwardly from edges of the bottom surface 71.

The chassis 70 may be formed of a metal considering strength and light emission efficiency. However, the material of the chassis 70 is not limited thereto.

As set forth above, in a light emitting module according to exemplary embodiments of the invention, a wavelength conversion part is coupled to a circuit board by the coupling of groove/protrusion and the like such that the wavelength conversion part covers a light emitting surface of a light source part mounted on the circuit board. This may enhance operational efficiency in terms of the manufacturing and assembly processes thereof while improving reliability by creating a stable coupling.

Since the wavelength conversion part including a phosphor is separately installed to be spaced apart from the light source part, defects occurring in a conventional method, in which a phosphor is directly applied to a light emitting device, such as changes in the luminance, sensitivity and refraction of light and discoloration and color stains caused by the deterioration of the phosphor applied thereto, may be avoided.

Since a predetermined space is provided between the light emitting surface of the light source part and the wavelength conversion part, heat generated from the light emitting device may be released rapidly and effectively.

Since the wavelength conversion part includes a quantum dot, color reproducibility and light emitting efficiency may be improved. The control of color coordinates may be facilitated by adjusting the particle size and concentration of the quantum dot.

While the present invention has been shown and described in connection with the exemplary embodiments, it will be apparent to those skilled in the art that modifications and variations can be made without departing from the spirit and scope of the invention as defined by the appended claims.

## Claims

1. A light emitting module comprising:
a circuit board;
at least one light source part disposed on the circuit board;
a wavelength conversion part coupled with the circuit board, the wavelength conversion part covering a light emitting surface of the light source part and converting a wavelength of light; and
a coupling part coupling the wavelength conversion part to the circuit board.

2. The light emitting module of claim 1, wherein the light source part includes:
a package body having a mounting area; and
a light emitting device disposed in the mounting area.

3. The light emitting module of claim 1, wherein the coupling part includes at least one opening portion and at least one protruding portion respectively provided on the circuit board and the wavelength conversion part such that the opening portion corresponds to the protruding portion.

4. The light emitting module of claim 3, wherein the protruding portion includes a pair of coupling portions divided by a space in a vertical direction and projecting portions at ends of the coupling portions such that the projecting portions are caught by the opening portion.

5. The light emitting module of claim 1, wherein the circuit board has a bar shape.

6. The light emitting module of claim 1, wherein the wavelength conversion part has a bar shape and includes extended portions at both ends thereof, the extended portions having the coupling part.

7. The light emiting module of claim 1, wherein the coupling part includes:
at least one opening portion formed in an upper surface of the circuit board; and
at least one protruding portion protruding downwardly from the wavelength conversion part and corresponding to the opening portion of the circuit board.

8. The light emitting module of claim 1, wherein the coupling part includes:
at least one opening portion formed in the wavelength conversion part; and
at least one protruding portion protruding from an upper surface of the circuit board and corresponding to the opening portion of the wavelength conversion part.

9. The light emitting module of claim 5, wherein the wavelength conversion part has vertical wall portions at both sides thereof, and
the coupling part includes linear protrusions formed inwardly of the vertical wall portions of the wavelength conversion part and groove portions formed at both sides of the circuit board and corresponding to the linear protrusions of the wavelength conversion part.

10. The light emitting module of claim 5, wherein the wavelength conversion part has vertical wall portions at both sides thereof, and
the coupling part includes linear protrusions formed outwardly at both sides of the circuit board and groove portions formed at inner surfaces of the vertical wall portions of the wavelength conversion part and corresponding to the linear protrusions of the circuit board.

11. A backlight unit comprising:
a light emitting module; and
a light guide plate disposed on a path of light emitted from the light emitting module,
wherein the light emitting module comprises:
at least one light source part disposed on a circuit board; and
a wavelength conversion part coupled with the circuit board by a coupling part, the wavelength conversion part covering a light emitting surface of the light source part and converting a wavelength of the light.

12. The backlight unit of claim 11, wherein the coupling part includes at least one opening portion and at least one protruding portion respectively provided on the circuit board and the wavelength conversion part such that the opening portion corresponds to the protruding portion.

13. The backlight unit of claim 11, further comprising a chassis having the light emitting module and the light guide plate therein.

14. The backlight unit of claim 13, wherein the circuit board is installed in a vertical manner to cause a circuit pattern thereof to be directed laterally with respect to a side wall of a chassis, and
the light source part is disposed on the circuit board to emit light in a direction in which the circuit pattern is formed.

15. The backlight unit of claim 13, wherein the circuit board is installed in a horizontal manner to cause a circuit pattern thereof to be directed upwardly with respect to a bottom surface of a chassis,
the light source part is disposed on the circuit board to emit light in a horizontal direction of the circuit board, and
the wavelength conversion part has a vertical wall portion on at least one side thereof so as to cover the light emitting surface of the light source part.
